(19) Europäisches Patentamt
European Patent Office
Office européen des brevets

(11) **EP 4 471 183 A1**

(12) **EUROPEAN PATENT APPLICATION**

(43) Date of publication:
**04.12.2024 Bulletin 2024/49**

(21) Application number: **23176672.6**

(22) Date of filing: **01.06.2023**

(51) International Patent Classification (IPC):
**C23C 28/04** (2006.01)  **C22C 29/08** (2006.01)
**C23C 28/00** (2006.01)  **C23C 30/00** (2006.01)
**C22C 1/051** (2023.01)

(52) Cooperative Patent Classification (CPC):
**C23C 28/044; C22C 1/051; C22C 29/08;**
**C23C 28/321; C23C 28/42; C23C 28/44;**
**C23C 30/005; B22F 2005/001**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(71) Applicant: **AB Sandvik Coromant**
**811 81 Sandviken (SE)**

(72) Inventors:
• **GARCIA, José Luis**
**811 81 Sandviken (SE)**
• **JOHNSON, Lars**
**811 81 Sandviken (SE)**

(74) Representative: **Sandvik**
**Sandvik Intellectual Property AB**
**811 81 Sandviken (SE)**

(54) **A COATED CUTTING TOOL**

(57) The present invention relates to a coated cutting tool (1) comprising a substrate (5) of cemented carbide and a coating (6), wherein the cemented carbide comprises WC grains and eta phase grains and metallic binder, wherein the metallic binder comprises Co and Cr, the Co content in the cemented carbide is 6-14 wt%, the eta phase content in the cemented carbide is 1-10 vol% and the average grain size of the eta phase grains is 0.5-5 $\mu$m, the Cr/Co weight ratio in the cemented carbide is 0.005-0.025, and, wherein the coating (6) comprises a nano-multilayer (8) of alternating layers of a first nanolayer (9) being $Ti_{1-x}Al_xN$, $0.35 \leq x \leq 0.70$, and a second nanolayer (10) being $Ti_{1-y}Si_yN$, $0.12 \leq y \leq 0.25$.

FIG. 2

EP 4 471 183 A1

**Description**

The present invention relates to a coated cutting tool comprising a nano-multilayer of (Ti,Si)N and (Ti,Al)N. The coating is deposited onto a cemented carbide substrate comprising distributed eta phase grains within a binder comprising cobalt and chromium.

Introduction

Metal machining operations include, for example, turning, milling, and drilling.

In order to provide a long tool life a coated cutting tool, such as an insert, should have high resistance against different types of wear, e.g., flank wear resistance, crater wear resistance, chipping resistance and flaking resistance.

Different metal machining operations affect a coated cutting tool in different ways. Turning, for example, is a continuous metal machining operation while milling is more intermittent in nature. In milling the thermal and mechanical load will vary over time. Thermal load induces thermal tensions which may lead to so-called thermal cracks, herein referred to as "comb cracks". Mechanical load may cause fatigue in the cutting edge leading to chipping, i.e., small fragments of the cutting edge loosening from the rest of the substrate. Thus, common wear types of a coated cutting tool in milling are cracking and chipping. A high level of toughness of the coating, in particular at the cutting edge, may reduce such chipping. Increasing the comb crack resistance and edge line toughness are thus of great importance to increase tool lifetime.

Heat resistant super alloys (HRSA) and titanium, i.e., ISO-S materials, are important materials in. e.g. the aerospace industry. Machining ISO-S materials is challenging due to the properties of the workpiece material. These materials are hard and smearing and puts special demands on the cutting tool. The ISO-S materials have, for example, poor heat conductivity which generates high temperatures during machining creating wear.

There is a continuing demand for coated cutting tools in which the coating has excellent properties in terms of wear resistance

There is an object of the present invention to provide a coated cutting tool which, at least, shows high chipping resistance and high toughness, especially in ISO-S milling applications.

The invention

It has now been provided a combination of a cemented carbide substrate comprising WC and an evenly distributed eta phase in a metallic binder comprising Co and Cr, the substrate further having a coating deposited thereon comprising a nano-multilayered coating of alternating (Ti,Si)N and (Ti,Al)N layers.

The coated cutting tool according to the invention shows a surprisingly high toughness behaviour in metal machining of titanium.

The present invention relates to a coated cutting tool comprising a substrate of cemented carbide and a coating, wherein the cemented carbide comprises WC grains and eta phase grains and metallic binder, wherein the metallic binder comprises Co and Cr, the Co content in the cemented carbide is 6-14 wt%, the eta phase content in the cemented carbide is 1-10 vol% and the average grain size of the eta phase grains is 0.5-5 $\mu$m, the Cr/Co weight ratio in the cemented carbide is 0.005-0.025, and, wherein the coating comprises a nano-multilayer of alternating layers of a first nanolayer being $Ti_{1-x}Al_xN$, $0.35 \leq x \leq 0.70$, and a second nanolayer being $Ti_{1-y}Si_yN$, $0.12 \leq y \leq 0.25$, a sequence of one first nanolayer and one second nanolayer forms a layer period, the average layer period thickness in the nano-multilayer is $\leq 10$ nm.

The cemented carbide of the present invention comprises WC grains and eta phase grains embedded in a metallic binder. The metallic binder comprises Co and Cr and also W that is dissolved into the metallic binder from the WC grains during the sintering of the cemented carbide.

The Co content in the cemented carbide of the present invention is suitably 7-13 wt% Co, preferably 8-12 wt% Co.

The Cr content in the cemented carbide of the present invention is suitably such that the Cr/Co weight ratio is 0.010-0.020.

The cemented carbide with a Cr/Co weight ratio range of the invention has a high solid solution strengthening. The work hardening properties of Co is improved, the hot hardness properties are improved, and also chemical resistance, i.e. corrosion resistance is improved. With Cr added in the cemented carbide the eta phase grains will include some of the Cr. Cr will also remain to some extent in solid solution in the metallic binder phase comprising Co. Cr will also act as a grain growth inhibitor during the sintering and restrict continued growth and coarsening of the WC grains. If the Cr content is too low Cr will still effect the WC grain size growth, but the solid solution effect described above will be limited. If the Cr is too high the cemented carbide will be too hard and too brittle for ISO-S milling applications.

The eta phase content in the cemented carbide of the present invention is 1-8 vol%, suitably 2-8 vol%, preferably 3-6 vol%. If the eta phase content is too high a large part of the Co content in the metallic binder is consumed into the eta phase grains and this would make the cemented carbide too brittle. If the eta phase content is too low there is an increased risk that the eta phase grains forms clusters and these are brittle instead of the well distributed eta grains. The amount of eta phase in the cemented carbide can be determined by image analysis of LOM (light optical microscope). The area fraction in the image is considered to correspond to the volume fraction in the cemented carbide.

The cemented carbide according to the present invention has a low carbon content so that eta phase grains are formed. By eta phase is herein meant carbides selected from $Me_{12}C$ and $Me_6C$ where Me is one or more metals selected from W and the binder phase metal or metals so the carbides could, for example, be $(W,Co,Cr)_6C$ and/or $(W,Co,Cr)_{12}C$.

In the present invention the cemented carbide comprises fine dispersed eta phase grains. The average grain size of the eta phase grains in the cemented carbide of the present invention is 0.5-5 $\mu$m, suitably 1-4 $\mu$m. The average grain size of the eta phase grains is herein defined as the average value of the maximum Feret diameter of the eta phase grains. This value can be determined by, e.g., image analysis on a light optical microscope (LOM) image.

The eta phase grains are suitably evenly distributed within the cemented carbide.

The distributed eta phase grains of the present invention are formed during the sintering process and the carbon deficiency and equilibrium temperature need to be controlled in the process to reach the desired eta phase grain size and content. Eta phase grains usually present themselves in an unwanted form as very large grains, which may be agglomerates om smaller grains, leading to a brittle cemented carbide. Such unwanted form of eta phase grains typically have grain sizes above 50 $\mu$m, or even above 100 $\mu$m.

The difference in substoichiometric carbon content between achieving the unwanted large grains, or agglomerates, of eta phase, and achieving the distributed eta phase grains having a small grain size, that is aimed for, can be very small. Being close to that limit requires monitoring the formation of the microstructure to make sure that the unwanted large grains or agglomerates are avoided. Carefully adjusting carbon contents and then monitor its result in terms of the obtained microstructure is a known working procedure to a person skilled in the art.

In one embodiment, the average WC grain size in the cemented carbide is 0.6-1.2 $\mu$m, preferably 0.7-1.0 $\mu$m.

In one embodiment of the present invention the cemented carbide comprises 70-90 vol% WC, preferably 75-85 vol% WC. The amount of WC in the cemented carbide can be determined by image analysis of LOM (light optical microscope). The area fraction in the image is considered to correspond to the volume fraction in the cemented carbide.

In one embodiment of the present invention the content of eta phase in a portion of the substrate adjacent to the surface of the substrate corresponds to the content in the innermost portion of the substrate. In one embodiment of the present invention, the eta phase distribution is constant throughout the whole cemented carbide substrate, i.e., the cemented carbide does not comprise any gradients of eta phase or zones without eta phase, like, e.g., in US 4,843,039. The distribution of the eta phase is preferably as even as possible.

In one embodiment of the present invention the cemented carbide comprises 8-28 vol% metallic binder, preferably 13-23 vol% metallic binder.

In one embodiment, the cemented carbide contains a metallic binder, eta phase, and balance WC.

The metallic binder comprises Co and Cr. Furthermore, some amount of W is dissolved in the metallic binder. W will inevitably be dissolved in the metallic binder during sintering and the exact amount depends on several things, such as the overall composition of the cemented carbide, the exact carbon content et cetera.

The cemented carbide in the present invention has a substoichiometric carbon content SCC within a certain range. Substoichiometric carbon content is a measure of the carbon content in relation to the stoichiometric value of carbon.

The stoichiometric carbon content may be calculated by assuming that the WC is completely stoichiometric, i.e. that the atomic ratio W:C is 1:1. Since other carbide forming elements are present, also their carbides are assumed to be stoichiometric.

This means that the term substoichiometric carbon content, SCC, as used herein is the total carbon content (in wt%) determined from chemical analysis minus the calculated stoichiometric carbon content (in wt%) based on WC and possible further carbides present in the cemented carbide.

As an example, if the stoichiometric carbon content for a particular cemented carbide is 5.60 wt%, and the same cemented carbide would be made, but with a carbon content of 5.30 wt%, the substoichiometric carbon would be -0.30 wt%.

To achieve the correct carbon content in the final sintered cemented carbide manufacturing, W and/or $W_2C$ is added in such amounts that there is a substoichiometric carbon content, SCC, in the sintered cemented carbide, -0.40 wt%$\leq$SCC$\leq$-0.16 wt%, or -0.35 wt%$\leq$SCC$\leq$-0.17 wt%.

The cemented carbide has such a low carbon content that eta phase is formed. The eta phase formed is, however, not present as large grains or agglomerates but is of a fine grain size and well distributed. The desired form of eta phase is provided by controlling the carbon balance carefully during manufacturing.

If the carbon content in the sintered cemented carbide is too low, i.e. lower than -0.40 wt% substoichiometric carbon content, the amount of eta phase becomes too large and the particle size increases considerably so the cemented carbide will be brittle. On the other hand, if the carbon content is higher than -0.16 wt% substoichiometric carbon content but still in the eta phase forming region, the formed eta phase will be unevenly distributed in the form of large agglomerates leading to a decrease in toughness of the cemented carbide.

The cemented carbide within the present invention can be made according to the following steps:

- providing raw material
- providing a milling liquid,
- milling, drying, pressing and sintering the powders into a cemented carbide.

Usually some carbon is lost during sintering due to the presence of oxygen. The oxygen will react with carbon and leave as CO or $CO_2$ during sintering thus shifting the carbon balance so that the added amount of one or more of W and $W_2C$ has to be adjusted. Exactly how much carbon that is lost during sintering depends on the raw material and production techniques used and it is up to the skilled person in the art to adjust the W and/or $W_2C$ additions so that the aimed eta phase characteristics in the sintered material are achieved.

The substoichiometric carbon value in the sintered material differs somewhat from that in the powder. This is due to that some of the carbon reacts with oxygen and outgas as CO or $CO_2$ during sintering, and this reduces the total final C content of the cemented carbide. Typically the substoichiometric carbon value in the sintered material is about 5-25% lower than the substoichiometric carbon value in the powder composition. For example, a substoichiometric carbon value in the powder composition of -0.20 wt% may give a substoichiometric carbon value in the sintered material of from about -0.21 wt% to about -0.25 wt%.

The stoichiometric carbon content in the cemented carbide can be determined by first measuring the total carbon content in a sample, for example by using a LECO CS 844 instrument. The cobalt content is also measured, for example by X-ray fluorescence analysis. By subtracting the cobalt and carbon amounts from the total weight of the sample the tungsten content is given which is then used to calculate the stoichiometric carbon content assuming the WC has a 1:1 ratio.

The grain size of the WC powder used is selected to provide a desired WC grain size in the final cemented carbide taking into account the effects of all components in the raw material powder mixture, and also any milling procedure used. The grain size (FSSS) of the WC powder is suitably between 2 and 7 $\mu$m.

The powder forming the binder phase is Co and is added in a desired amount. Furthermore, Cr is added in a desired amount, suitably in the form of $Cr_3C_2$, and will partly be included in an eta phase and partly be dissolved in the binder phase in the final cemented carbide.

The slurry comprising powders forming hard constituents and powders forming the binder phase are suitably mixed by a milling operation, either in a ball mill or attritor mill. Any liquid commonly used as a milling liquid in conventional cemented carbide manufacturing can be used. The slurry containing the powdered materials are then dried, suitably forming agglomerated granules.

Green bodies are subsequently formed from the dried powders/granules by a pressing operation such as uniaxial pressing, multiaxial pressing etc.

The green bodies formed from the powders/granules made are subsequently sintered according to any conventional sintering methods e.g. vacuum sintering, Sinter HIP, spark plasma sintering, gas pressure sintering (GPS) etc.

The sintering temperature is typically between 1300 and 1580 °C, or between 1360 and 1450°C.

The coating comprises a nano-multilayer of alternating layers of a first nanolayer being $Ti_{1-x}Al_xN$, $0.35 \leq x \leq 0.70$, and a second nanolayer being $Ti_{1-y}Si_yN$, $0.12 \leq y \leq 0.25$.

For the first nanolayer $Ti_{1-x}Al_xN$, suitably $0.45 \leq x \leq 0.70$, preferably $0.55 \leq x \leq 0.65$.

For the second nanolayer $Ti_{1-y}Si_yN$, suitably $0.14 \leq y \leq 0.23$, preferably $0.17 \leq y \leq 0.21$.

The average layer period thickness of the nano-multilayer is suitably from 2 to 7 nm, preferably from 3 to 6 nm.

In one embodiment, the nano-multilayer has a columnar structure with an average column width of $\leq$ 100 nm, or $\leq$ 70 nm. In one embodiment the average column width of the nano-multilayer is from 5 to 100 nm, or from 10 to 70 nm, or from 25 to 70 nm.

The thickness of the nano-multilayer is suitably from about 0.5 to about 10 $\mu$m, preferably from about 0.5 to about 5 $\mu$m, more preferably from about 1 to about 3 $\mu$m.

The nano-multilayer is suitably a cathodic arc evaporation deposited layer.

In one embodiment the coating comprises a layer of TiN, (Ti,Al)N or (Cr,Al)N situated between the substrate and the nano-multilayer, preferably as an innermost layer of the coating. Preferably, this layer is (Ti,Al)N. If (Ti,Al)N is used then the (Ti,Al)N is suitably $Ti_{1-z}Al_zN$, $0.35 \leq z \leq 0.70$, preferably $0.45 \leq z \leq 0.70$, most preferably $0.50 \leq z \leq 0.65$. In a preferred embodiment the Ti-Al relation in the (Ti,Al)N is the same as the Ti-Al relation in the first nanolayer of the nano-multilayer. The thickness of this layer can be from about 0.1 to about 2 $\mu$m, preferably from about 0.5 to about 1.5 $\mu$m.

In one embodiment the coating comprises a top layer of (Ti,Si)N. The (Ti,Si)N is suitably $Ti_{1-v}Si_vN$, $0.12 \leq v \leq 0.25$, or $0.14 \leq v \leq 0.23$, or $0.17 \leq v \leq 0.21$. In a preferred embodiment the Ti-Si relation in the top layer of (Ti,Si)N is the same as the Ti-Si relation in the second nanolayer of the nano-multilayer. The thickness of this top layer can be from about 0.02 to about 0.5 $\mu$m, preferably from about 0.05 to about 0.2 $\mu$m.

In a preferred embodiment, the coating comprises a nano-multilayer of alternating layers of a first nanolayer being $Ti_{1-x}Al_xN$, $0.55 \leq x \leq 0.65$, and a second nanolayer being $Ti_{1-y}Si_yN$, $0.17 \leq y \leq 0.21$, the average layer period thickness of the nano-multilayer is from 3 to 6 nm, the average column width in the nano-multilayer is from 25 to 70 nm, the thickness of the nano-multilayer is from about 1 to about 3 $\mu$m, there is an innermost layer of (Ti,Al)N below the nano-multilayer closest to the substrate having a thickness of from about 0.5 to about 1.5 $\mu$m.

The coated cutting tool is suitably a cutting tool insert, a drill, or a solid end-mill, for metal machining. Preferably, the cutting tool insert is a milling insert or a solid endmill.

Brief descriptions of the drawings

Figure 1 shows a schematic view of one embodiment of a cutting tool being a milling insert.

Figure 2 shows a schematic view of a cross section of an embodiment of the coated cutting tool of the present invention showing a substrate and a coating comprising different layers.

Figure 3 shows a LOM (Light Optical Microscope) image of a cross-section of an embodiment of the substrate used in the present invention.

Figure 4 shows a magnification of the lower right corner of the LOM image of Figure 3.

Detailed description of embodiments in drawings

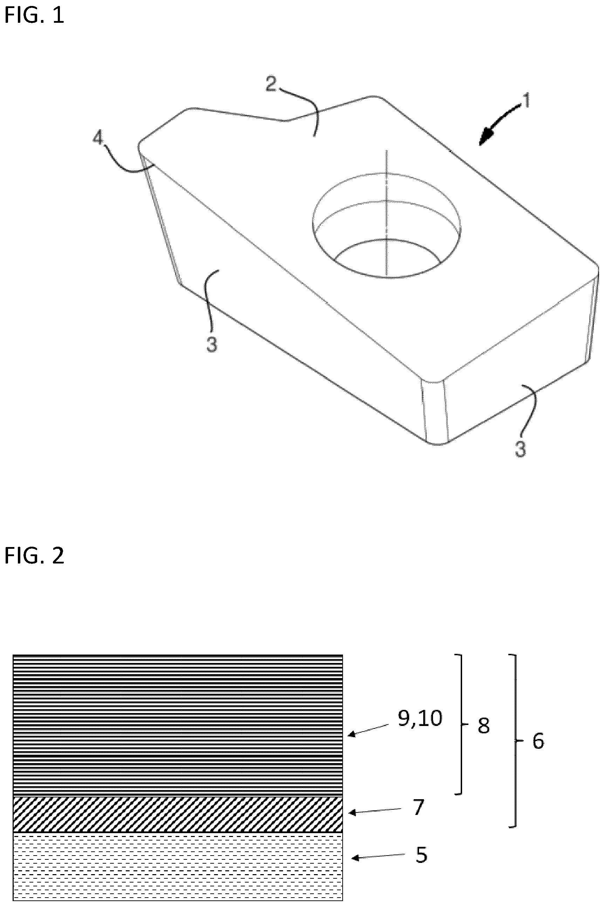

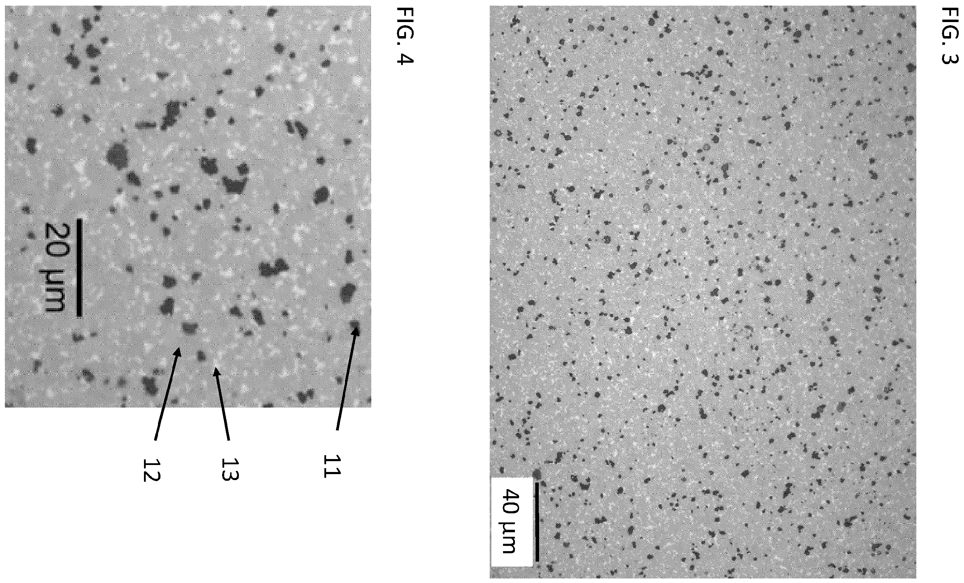

Figure 1 shows a schematic view of one embodiment of a cutting tool (1) having a rake face (2) and flank faces (3) and a cutting edge (4). The cutting tool (1) is in this embodiment a milling insert. Figure 2 shows a schematic view of a cross section of an embodiment of the coated cutting tool of the present invention having a substrate body (5) and a coating (6). The coating (6) consisting of an inner (Ti,Al)N layer (7) followed by a nano-multilayer (8) of alternating nanolayers being $Ti_{1-x}Al_xN$ (9) and nanolayers being $Ti_{1-y}Si_yN$ (10). Figure 3 shows a LOM (Light Optical Microscope) of a cross-section of an embodiment of the cemented carbide substrate used in the present invention. The cemented carbide comprises eta phase grains (dark), WC grains (grey) and a metallic binder (light grey-white). Figure 4 shows a magnification of the lower right corner of the LOM image of Figure 3. The cemented carbide comprises eta phase grains (11), WC grains (12) and a metallic binder (13).

Definitions and Methods

The amount of eta phase in the cemented carbide was determined by image analysis of LOM (light optical microscope) using the software Image J using the "Analyze particles" function with "include holes" and the "0-Infinity" filter settings. Prior to the measurements, color LOM images were converted into 8-bit black and white images using Automatic threshold setup. The magnifications of the images were 1000X and 2000X, two measurements were done at each magnification and the values in Table 2 are an average value of these. The value in the table is thus an average from a total of four image analyses performed on the two images, two measurements on each image. The area fraction in the image is considered to correspond to the volume fraction in the cemented carbide. The volume fraction of WC can be determined in the corresponding way as the eta phase volume fraction.

The average grain size of the eta phase grains is herein defined as the average value of the maximum feret diameter of the eta phase grains. This value was herein determined by image analysis on a light optical microscope (LOM) image using the software Image J using the "Analyze particles" function with "include holes" and the "0-Infinity" filter settings. The Feret size option "exclude on edges" was additionally activated in the "Analyze particles" function. Prior to the measurements, color LOM images were converted into 8-bit black and white images using Automatic threshold setup. The images used for the analysis were LOM images with a magnification of 1000X and 10 images were processed and maximum Feret diameters were obtained for each image and an overall average value of maximum Feret diameter was calculated.

The stoichiometric carbon content in the sintered cemented carbide can be calculated by first measuring the total carbon content in the sintered cemented carbide. A suitable instrument is used, such as a LECO CS 844 instrument. The sample was crushed prior to the analysis. The W, Co and Cr content is measured with XRF (X-ray fluorescence), for example by using a Panalytical Axios Max Advanced instrument. By subtracting the cobalt, the chromium and carbon amounts from the total weight of the sample, the W content is obtained which is then used to calculate the stoichiometric carbon content, assuming the WC has a 1:1 ratio. By subtracting the stoichiometric carbon content from the total carbon content as already measured, the substoichiometric carbon value is obtained.

The grain size of the WC, d, is herein determined from the value of magnetic coercivity. The relationship between coercivity and grain size of WC is described, e.g., in Roebuck et al., Measurement Good Practice No. 20, National Physical Laboratory, ISSN 1368-6550, November 1999, Revised February 2009, Section 3.4.3, pages 19-20. For the purposes of this application the grain size of the WC, d, is determined according to formula (8) on page 20 in the above-mentioned literature:

$K=(c_1+d_1W_{Co})+ (c_2+d_2W_{Co})/d$. Re-arranging one gets:

$$d = (c_2+d_2W_{Co})/ (K-(c_1+d_1W_{Co})),$$

wherein

d= WC grain size of the cemented carbide body, K= coercivity of the cemented carbide body in kA/m, herein measured according to standard DIN IEC 60404-7, $W_{Co}$ = wt% Co in the cemented carbide body, $c_1$ = 1.44, $c_2$ = 12.47, $d_1$ = 0.04, and $d_2$ = -0.37.

The layer thicknesses of the coating were measured in a polished cross section in an SEM image.

By the term "average layer period thickness" is meant the average thickness of a combination A-B in the nano-multilayer coating of a first nanolayer A and second nanolayer B in a nano-multilayer A-B-A-B-A... If the deposition process is known the calculation can be made by dividing the total thickness of the nano-multilayer by the number of A-B depositions (which corresponds to the number of revolutions when depositing a substrate in a rotating manner).

Alternatively the calculation being made by using TEM analysis of a cross-section of the nano-multilayer counting the number of consecutive A-B nanolayer combinations over a length of at least 250 nm and calculating an average value.

By the term "average column width" in the nano-multilayer is meant an average value of the crystallite columns, or "grains", in the nano-multilayer. At least a length of 500 nm, perpendicular to the growth direction of the layer, is considered and column widths are measured over this length on at least 4 different places in the nano-multilayer at a distance of 500 nm from the lower interface of the nano-multilayer.

If the nano-multilayer has a total thickness of only 0.5 $\mu$m then the measuring places are located just below the outer surface of the nano-multilayer. Suitably methods of analysis include transmission electron microscopy (TEM).

Examples

Example 1:

Coated cutting tools were produced. Sintered cemented carbide cutting tool insert blanks of the geometry R390-11 were used.

The composition of the first cemented carbide was 10.40 wt% Co, 0.15 wt% Cr, and rest WC - Substrate 1 (part of invention). The composition of the cemented carbide of the reference was 11.2 wt% Co, 1.12 wt% Cr and rest WC - Substrate 2 (reference).

The cemented carbides were made from raw material powders in accordance with Table 1.

Table 1. Powder composition

| Sample | $Cr_3C_2$ [wt%] | Co [wt%] | WC [wt%] | WC grain size [$\mu$m] | W addition [wt%] |
|---|---|---|---|---|---|
| Substrate 1 (part of invention) | 0.17 | 10.70 | Balance | 5.5-6.3 | 3.54 |
| Substrate 2 (reference) | 0 | 11.20 | Balance | 0.81-0.87 | - |

The powders were milled in a ball mill together with a milling liquid (water/ethanol with a ratio of 9/91) and an organic binder, 2 wt % PEG. The amount of PEG is not included in the dry powder weight presented in Table 1. After the milling the slurry was dried. The dried agglomerates were then pressed into a green body. The green body was sintered in 40 mbar in Ar and CO at 1410°C.

The chemical composition of the sintered cemented carbide is measured with XRF (X-ray fluorescence) using a Panalytical Axios Max Advanced instrument.

The carbon in the powder was adjusted to achieve the desired microstructure in the sintered cemented carbides.

The contents of Co and Cr in the sintered cemented carbide substrates are given in Table 2. Also the values of coercivity are given and the calculated average WC grain size.

Table 2. Cemented carbide composition and WC grain size

| Sample | Coercivity, Hc [kA/m] | WC average grain size in sintered [$\mu$m] | Cr [wt%] | Co [wt%] | Cr/Co [wt ratio] |
|---|---|---|---|---|---|
| Substrate 1 (part of invention) | 11.83 | 0.86 | 0.15 | 10.40 | 0.014 |
| Substrate 2 (reference) | 18.75 | 0.49 | 0 | 11.20 | 0 |

The eta phase content and the average grain size of the eta phase grains were measured in accordance with the methods herein disclosed. Table 3 shows the results. The eta phase grains in the samples containing eta phase were evenly distributed through the whole substrate body, no gradient in eta phase content was observed in the samples. No gamma phase grains, no very large eta phase grains and no graphite was found in the cemented carbide.

Table 3. Carbon content and eta phase in substrate

| Sample | Eta phase [area%] | Eta phase average grain size [$\mu$m] |
|---|---|---|
| Substrate 1 (part of invention) | 5.03 | 2.0 |
| Substrate 2 (reference) | 0 | - |

The cemented carbide blanks were coated by cathodic arc evaporation in a vacuum chamber comprising arc flanges.

Targets of $Ti_{0.80}Si_{0.20}$ were mounted in two of the flanges in opposite to each other. Targets of $Ti_{0.40}Al_{0.60}$ were mounted in two flanges also in opposite to each other. Ti targets were mounted in 1 flange. The targets were circular and planar with a diameter of 100 mm available on the open market. Suitable arc sources to be used are the ones called Super Fine Cathode (SFC) from Kobelco (Kobe Steel Ltd.).

Uncoated blanks of both Substrate 1 and Substrate 2 were mounted on pins that underwent a three-fold rotation in the PVD chamber.

The chamber was pumped down to high vacuum (less than $10^{-2}$ Pa) and heated to 550-650°C by heaters located inside the chamber. The blanks were then etched for 60 minutes in an Ar plasma.

An etching treatment of the substrates with Ti ions was then performed in order to enhance the adhesion of the coating to the substrate. This treatment was made for four minutes at a DC bias voltage of -200V, at an arc current of 150 A applied to the Ti targets, and at an Ar pressure of 0.7 Pa.

Then, an about 0.8 $\mu$m thick innermost layer of $Ti_{0.40}Al_{0.60}N$ was, at first, deposited. The chamber pressure (reaction pressure) was set to 4 Pa of $N_2$ gas, and a DC bias voltage of -30 V (relative to the chamber walls) applied to the blank assembly. The cathodes of the Ti-Al targets were run in an arc discharge mode at a current of 150 A (each) for 40 minutes.

A nano-multilayer of (Ti,Si)N and (Ti,Al)N was then deposited onto the innermost layer of $Ti_{0.40}Al_{0.60}N$.

The chamber pressure (reaction pressure) was set to 4 Pa of $N_2$ gas, and a DC bias voltage of -40 V (relative to the chamber walls) was applied to the blank assembly. The cathodes of the Ti-Al targets and Ti-Si targets were run in an arc discharge mode at an arc current of 150 A (each) for 30 minutes (4 flanges). A nano-multilayer coating having a thickness of about 1.3 $\mu$m was deposited on the blanks. Due to the target setup two nanolayer periods are formed per revolution of the substrate table. The table rotational speed was adjusted so to provide an average nanolayer period thickness of about 4 nm.

Finally, an about 0.1 $\mu$m thick top layer of $Ti_{0.80}Al_{0.20}N$ was deposited. The chamber pressure (reaction pressure) was set to 4 Pa of $N_2$ gas, and a DC bias voltage of -70 V (relative to the chamber walls) was applied to the blank assembly. The cathodes of the Ti-Al targets and Ti-Si targets were run in an arc discharge mode at an arc current of 150 A (each) for 5 minutes (2 flanges).

The inserts of Substrate 1 having the coating comprising the $Ti_{0.40}Al_{0.60}N/Ti_{0.80}Si_{0.20}N$ nano-multilayer are denoted "Sample 1 (invention)".

The inserts of Substrate 2 (reference) having the coating comprising the $Ti_{0.40}Al_{0.60}N/ Ti_{0.80}Si_{0.20}N$ nano-multilayer are denoted "Sample 2 (comparative)".

As a further reference sample to be included in the performance testing a coated cutting tool was made by, in a separate deposition run, depositing an about 2 $\mu$m layer of (Ti,Al)N using a target composition of $Ti_{0.33}Al_{0.67}$.

The (Ti,Al)N layer was deposited on sintered cemented carbide cutting tool insert blanks being of the type Substrate 2 (reference) of the geometry R390-11T308M-PM. By using this reference TiAlN layer, any kind of possible differences between performance testing runs were compensated for and results from different test runs could be compared. The cemented carbide blanks were coated by cathodic arc evaporation in a PVD vacuum chamber comprising several arc flanges, each flange comprising several cathode evaporators.

Targets of $Ti_{0.33}Al_{0.67}$ were mounted in evaporators. Suitable target technology packages for arc evaporation are available from suppliers on the market such as IHI Hauzer Techno Coating B.V., Kobelco (Kobe Steel Ltd.) and Oerlikon Balzers.

The PVD chamber comprises a circular substrate table and the uncoated cutting tool insert blanks were mounted on pins. The mounting of the inserts was such that the flank faces of the inserts would directly face the targets during rotation.

The chamber pressure (reaction pressure) was set to 1 Pa of $N_2$ gas, and a DC bias voltage of -100 V (relative to the chamber walls) was applied to the blank assembly. The cathodes were run in an arc discharge mode at a current of 140 A (each). The inserts of Substrate 2 (reference) having the reference coating $Ti_{0.33}Al_{0.67}N$ are denoted "Sample 3 (reference)".

In order to confirm the actual elemental composition in the nano-multilayer the average composition was analysed by using energy-dispersive X-ray spectroscopy (EDS) for some samples. The EDS measurements were made over a distance comprising a number of nanolayers in SEM on a cross-section of the coating.

The result was that deviations of only 1-2 percentage units from the theoretical composition were seen. This is within the accuracy of the EDS method. It is therefore concluded that the actual elemental composition of Ti, Al and Si in the layers of the nano-multilayer substantially correspond well to the respective target compositions used. Also for the innermost TiAlN layer and the TiSiN top layer the respective target composition is considered to correspond to the compositions in the deposited layers.

Example 2:

Cutting tests were made in order to determine the performance of the samples made.

Explanations to terms used:

The following expressions/terms are commonly used in metal cutting, but nevertheless explained:

Vc (m/min):        cutting speed in meters per minute
fz (mm/tooth):     feed rate in millimeter per tooth
$a_e$ (mm):        radial depth of cut in millimeter
$a_p$ (mm):        axial depth of cut in millimeter
z: (number)        number of teeth in the cutter

Toughness test in Titanium:

The test evaluates the resistance towards large breakages. The test is an entrance test, run by up-milling, positioning the cutter with a 0° exit, i.e. with an engagement (ae) of half of the cutter diameter. Under these conditions the chip thickness is maximised exiting the work piece material. These conditions render the operation highly toughness demanding. The test is run in the y-direction of the test piece and the number of entrances until the cut-off criteria is recorded. The wear of the variants is measured continuously during the test. To obtain the same conditions during the testing, a "cleaning cutter" is used to clean the surface when the number of entrances is reached for each row. The "cleaning cutter" is also used at the first entrance for each row (right side x-direction), due to different conditions at this entrance.

Work piece material: Ti6Al4V
Charge: 04696
MC S4.2.Z.AN
Dim: 600x200x50mm
Hardness: 330 HB
Cutter: R390-32mm (R390-032A32-11 M)
Tool length: 132 mm
Coolant: Internal 10 bar
Vc =35m/min
fz =0.20 mm
$a_e$= 16 mm
Depth of entrance=27 mm

$a_p$=2.0 mm
z=1
Insert type: R390-11T308M-MM
Cut off criteria: Measured breakage/chipping $\geq$ 1.0 mm on rake or flank face.

The tool life is reported as number of entrances in order to achieve the cut off criteria.

Uncoated cutting tool blanks of the geometry R390-11 of Substrates 1 and 2, see Example 1, were tested in the "Toughness test in titanium". The results are seen in Table 4.

Table 4. Toughness test (uncoated)

| Substrate | Number of entrances |
|---|---|
| Substrate 1 (part of invention) | 27 |
| Substrate 2 (reference) | 6.5 |

Thus, Substrate 1 showed about four times longer tool life in the toughness test.

Furthermore, coated cutting tools of Example 1 were tested in the "Toughness test in titanium". Since two diferent test runs were made, there are reference samples (Sample 2 and Sample 4) tested along with Sample 1 (invention) and Sample 3 (comparative), respectively, so that a comparison between the preformance of Sample 1 and Sample 3 can be made.

The results are seen in Table 6.

Table 6. Toughness test (coated)

| Sample | Substrate + coating | Test run | Number of entrances |
|---|---|---|---|
| "Sample 1 (invention)" | Substrate 1 with $Ti_{0.40}Al_{0.60}N/Ti_{0.80}Si_{0.20}N$ nano-multilayer | 1 | 44 (730% of reference) |
| "Sample 3 (reference)" | Substrate 2 with reference coating $Ti_{0.33}Al_{0.67}N$ | 1 | 6 (100%) |
| "Sample 2 (comparative)" | Substrate 2 with $Ti_{0.40}Al_{0.60}N/Ti_{0.80}Si_{0.20}N$ nano-multilayer | 2 | 16 (107% of reference) |
| "Sample 3 (reference)" | Substrate 2 with reference coating $Ti_{0.33}Al_{0.67}N$ | 2 | 15 (100%) |

Thus, Sample 1, which is a combination of Substrate 1 with a coating comprising the $Ti_{0.40}Al_{0.60}N/Ti_{0.80}Si_{0.20}N$ nano-multilayer, showed about seven times longer tool life in the toughness test than the reference Sample 3 (Substrate 2 + Ref. coating $Ti_{0.33}Al_{0.67}N$.

The comparative Sample 2, which is a combination of Substrate 2 with a coating comprising the $Ti_{0.40}Al_{0.60}N/Ti_{0.80}Si_{0.20}N$ nano-multilayer, showed no more than equal performance in the toughness test to the reference Sample 3 (Substrate 2 + Ref. coating $Ti_{0.33}Al_{0.67}N$.

## Claims

1. A coated cutting tool (1) comprising a substrate (5) of cemented carbide and a coating (6), wherein

   - the cemented carbide comprises WC grains and eta phase grains and metallic binder, wherein the metallic binder comprises Co and Cr, the Co content in the cemented carbide is 6-14 wt%, the eta phase content in the cemented carbide is 1-10 vol% and the average grain size of the eta phase grains is 0.5-5 $\mu$m, the Cr/Co weight ratio in the cemented carbide is 0.005-0.025, and, wherein
   - the coating (6) comprises a nano-multilayer (8) of alternating layers of a first nanolayer (9) being $Ti_{1-x}Al_xN$, $0.35 \leq x \leq 0.70$, and a second nanolayer (10) being $Ti_{1-y}Si_yN$, $0.12 \leq y \leq 0.25$, a sequence of one first nanolayer (9) and one second nanolayer (10) forms a layer period, the average layer period thickness in the nano-multilayer (8) is $\leq$ 10 nm.

2. The coated cutting tool according to claim 1, wherein the Co content in the cemented carbide is 7-13 wt%.

3. The coated cutting tool according to any one of claims 1-2, wherein the Cr/Co ratio in the cemented carbide is 0.010-0.020.

4. The coated cutting tool according to any one of claims 1-3, wherein the eta phase content in the cemented carbide is 2-8 vol%.

5. The coated cutting tool according to any one of claims 1-4, wherein the content of eta phase in a portion of the substrate adjacent to the surface of the substrate corresponds to the content of eta phase in the innermost portion of the substrate.

6. A coated cutting tool (1) according to any one of claims 1-5, wherein for the first nanolayer (9) $Ti_{1-x}Al_xN$, $0.45 \leq x \leq 0.70$.

7. A coated cutting tool (1) according to any one of claims 1-6, wherein for the second nanolayer (10) $Ti_{1-y}Si_yN$, $0.14 \leq y \leq 0.23$.

8. A coated cutting tool (1) according to any one of claims 1-7, wherein the average layer period thickness in the nano-multilayer (8) is from 2 to 7 nm.

9. A coated cutting tool (1) according to any one of claims 1-8, wherein the nano-multilayer (8) has a columnar structure with an average column width of $\leq$ 100 nm.

10. A coated cutting tool (1) according to any one of claims 1-9, wherein the thickness of the nano-multilayer (8) is from about 0.5 to about 15 $\mu$m.

11. A coated cutting tool (1) according to any one of claims 1-10, wherein the thickness of the nano-multilayer (8) is from about 0.5 to about 5 $\mu$m.

12. A coated cutting tool (1) according to any one of claims 1-11, wherein the coating (6) comprises a layer (7) of TiN, (Ti,Al)N or (Cr,Al)N situated between the substrate and the nano-multilayer (8) having a thickness of from about 0.1 to about 2 $\mu$m.

13. A coated cutting tool (1) according to claim 12, wherein the innermost layer (7) is $Ti_{1-z}Al_zN$, $0.35 \leq z \leq 0.70$.

14. A coated cutting tool (1) according to any one of claims 1-13, wherein the coated cutting tool (1) is a cutting tool insert, a drill, or a solid end-mill, for metal machining.

FIG. 1

FIG. 2

FIG. 3

40 µm

FIG. 4

11

13

12

20 µm

Europäisches
Patentamt

European
Patent Office

Office européen
des brevets

# EUROPEAN SEARCH REPORT

**Application Number**

EP 23 17 6672

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | JP 5 651053 B2 (SUMITOMO ELECTRIC HARDMETAL CORP; SUMITOMO ELECTRIC INDUSTRIES) 7 January 2015 (2015-01-07) * paragraphs [0081] – [0090]; example 105; table 1 * | 1-14 | INV.<br>C23C28/04<br>C22C29/08<br>C23C28/00<br>C23C30/00<br>C22C1/051 |
| A | JP 2009 034811 A (SANDVIK INTELLECTUAL PROPERTY) 19 February 2009 (2009-02-19) * paragraphs [0001], [0026], [0027] * | 1-14 | |
| A | US 2009/003943 A1 (PETTERSSON MARIE [SE] ET AL) 1 January 2009 (2009-01-01) * paragraphs [0002], [0012], [0030], [0031] * | 1-14 | |
| A | US 2008/295658 A1 (AHLGREN M; ANDERES J ET AL.) 4 December 2008 (2008-12-04) * paragraphs [0002], [0012], [0037], [0039] * | 1-14 | |
| A | US 2019/358707 A1 (GARCIA JOSE LUIS [SE] ET AL) 28 November 2019 (2019-11-28) * paragraphs [0006], [0007], [0023], [0025], [0028]; claims 1,6,7 * | 1-14 | **TECHNICAL FIELDS SEARCHED (IPC)**<br><br>C23C<br>C22C<br>B22F |
| A | US 2019/010583 A1 (ÅKESSON LEIF [SE] ET AL) 10 January 2019 (2019-01-10) * paragraphs [0007], [0008], [0025], [0027], [0030]; claims 1,3,4 * | 1-14 | |

The present search report has been drawn up for all claims

| Place of search | Date of completion of the search | Examiner |
|---|---|---|
| The Hague | 7 November 2023 | Martinavicius, A |

EPO FORM 1503 03.82 (P04C01)

## ANNEX TO THE EUROPEAN SEARCH REPORT
## ON EUROPEAN PATENT APPLICATION NO.

EP 23 17 6672

This annex lists the patent family members relating to the patent documents cited in the above-mentioned European search report.
The members are as contained in the European Patent Office EDP file on
The European Patent Office is in no way liable for these particulars which are merely given for the purpose of information.

07-11-2023

| Patent document cited in search report | | Publication date | Patent family member(s) | | Publication date |
|---|---|---|---|---|---|
| JP 5651053 | B2 | 07-01-2015 | JP | 5651053 B2 | 07-01-2015 |
| | | | JP | 2012193406 A | 11-10-2012 |
| JP 2009034811 | A | 19-02-2009 | NONE | | |
| US 2009003943 | A1 | 01-01-2009 | AT | E484608 T1 | 15-10-2010 |
| | | | CN | 101318229 A | 10-12-2008 |
| | | | CN | 101318230 A | 10-12-2008 |
| | | | CN | 101353748 A | 28-01-2009 |
| | | | EP | 2006413 A1 | 24-12-2008 |
| | | | EP | 2036997 A1 | 18-03-2009 |
| | | | JP | 4944062 B2 | 30-05-2012 |
| | | | JP | 2009061579 A | 26-03-2009 |
| | | | JP | 2009066747 A | 02-04-2009 |
| | | | KR | 20080106083 A | 04-12-2008 |
| | | | KR | 20080106084 A | 04-12-2008 |
| | | | US | 2009003943 A1 | 01-01-2009 |
| US 2008295658 | A1 | 04-12-2008 | NONE | | |
| US 2019358707 | A1 | 28-11-2019 | CN | 110023522 A | 16-07-2019 |
| | | | EP | 3559290 A1 | 30-10-2019 |
| | | | JP | 6898450 B2 | 07-07-2021 |
| | | | JP | 2020504780 A | 13-02-2020 |
| | | | KR | 20190098964 A | 23-08-2019 |
| | | | RU | 2726135 C1 | 09-07-2020 |
| | | | US | 2019358707 A1 | 28-11-2019 |
| | | | WO | 2018113923 A1 | 28-06-2018 |
| US 2019010583 | A1 | 10-01-2019 | CN | 108367357 A | 03-08-2018 |
| | | | EP | 3393703 A1 | 31-10-2018 |
| | | | JP | 7104626 B2 | 21-07-2022 |
| | | | JP | 2019506301 A | 07-03-2019 |
| | | | KR | 20180095909 A | 28-08-2018 |
| | | | RU | 2018126789 A | 23-01-2020 |
| | | | US | 2019010583 A1 | 10-01-2019 |
| | | | WO | 2017108610 A1 | 29-06-2017 |

EPO FORM P0459

For more details about this annex : see Official Journal of the European Patent Office, No. 12/82

**EP 4 471 183 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4843039 A

**Non-patent literature cited in the description**

- **ROEBUCK et al.** Measurement Good Practice. National Physical Laboratory, November 1999, 19-20